# DEMANDE DE BREVET EUROPEEN

(11) **EP 1 722 281 A1**
(43) Date de publication de la demande: **15.11.2006**
(21) Numéro de dépôt: 05103979.0
(22) Date de dépôt: 12.05.2005
(51) Int. Cl.: G04B 19/04, G04D 3/00

(54) **Organe d'affichage analogique en matériau cristallin, pièce d'horlogerie pourvue d'un tel organe d'affichage, et procédé pour sa fabrication**

(71) Demandeur: ETA SA Manufacture Horlogère Suisse, 2540 Grenchen (CH)
(72) Inventeur: Meister, Pierre-André, 2502, Bienne (CH); Fleury, Emmanuel, CH-2740 Moutier (CH); Zanetta, André, CH-2000 Neuchâtel 11 (CH); Blondeau, Fabien, CH-2525 Le Landeron (CH)
(74) Mandataire: Ravenel, Thierry Gérard Louis

(57) **Abrégé**

L'invention propose un organe d'affichage analogique équipant une pièce d'horlogerie, du type comportant un corps principal, caractérisé en ce que le corps principal est réalisé en matériau cristallin à base de silicium.

L'invention propose aussi une pièce d'horlogerie pourvue d'un tel organe d'affichage.

L'invention propose encore un procédé de fabrication d'organes d'affichage analogique destinés à équiper des pièces d'horlogerie, chaque organe d'affichage analogique comportant un corps principal, caractérisé en ce qu'il comporte au moins une étape de micro-usinage d'une plaque en matériau cristallin à base de silicium de manière à réaliser au moins un corps principal en un tel matériau.

## Description

L'invention concerne un organe d'affichage analogique tel qu'une aiguille de pièce d'horlogerie.

L'invention concerne aussi une pièce d'horlogerie et un procédé de fabrication d'un organe d'affichage.

La fabrication d'une aiguille destinée à être utilisée comme organe d'affichage dans une pièce d'horlogerie est particulièrement complexe, en particulier lorsqu'il s'agit d'une aiguille destinée à équiper une pièce d'horlogerie haut de gamme, pour laquelle l'aiguille doit présenter un aspect de surface particulièrement soigné, éventuellement muni de facettes.

Actuellement, les aiguilles sont fabriquées en laiton, en acier, en or, en aluminium, ou en alliage spécial. Elles peuvent être traitées galvaniquement, recouvertes de peinture, oxydées, ou brutes lorsque le matériau utilisé est l'or. Elles sont généralement réalisées par usinage ou par estampage.

Les matériaux comme l'or, l'aluminium, ou les alliages spéciaux présentent l'inconvénient d'être relativement coûteux. L'utilisation de l'acier est très pénalisante en terme de poids.

Les aiguilles en laiton présentent un bon compromis en matière de coût et de poids puisque le laiton bénéficie d'une masse volumique relativement faible, de l'ordre de 8,6 kg/dm3.

Toutefois, les techniques d'usinage et d'estampage de ces matériaux ne permettent pas toujours d'obtenir une précision dimensionnelle satisfaisante, ce qui nécessite des opérations supplémentaires d'ébavurage, de polissage, etc. pour obtenir la forme finale de l'aiguille.

De plus, il est généralement nécessaire d'appliquer sur les aiguilles de multiples traitements pour garantir de bons états de surface et un bon maintien dans le temps des caractéristiques dimensionnelles de l'aiguille.

Par ailleurs, les techniques actuelles de fabrication des aiguilles ne permettent pas de réaliser toutes les formes souhaitées, de sorte que la créativité des concepteurs de pièces d'horlogerie s'en trouve bridée.

La présente invention vise à proposer une aiguille qui soit plus facile à fabriquer tout en offrant une grande liberté de conception de sa forme, et qui puisse être fabriquée en série de manière à minimiser les coûts de production.

Dans ce but, l'invention propose un organe d'affichage analogique équipant une pièce d'horlogerie, du type comportant un corps principal, caractérisé en ce que le corps principal est réalisé en matériau cristallin à base de silicium.

L'organe d'affichage selon l'invention présente l'avantage de pouvoir être facilement fabriqué en utilisant des technologies éprouvées dans la microélectronique pour la fabrication de circuits intégrés et dans la micromécanique pour la fabrication de micro-structures.

Le silicium présente l'avantage d'être très léger, puisque sa masse volumique est d'environ 2,49 kg/dm3, ce qui permet de minimiser les dimensions et la consommation énergétique des moyens d'entraînement. En effet, le poids et l'inertie de l'aiguille sont déterminants pour le dimensionnement des moyens d'entraînement de l'aiguille et pour la consommation énergétique de ces moyens d'entraînement.

Selon d'autres caractéristiques de l'invention :
- la surface supérieure du corps principal comporte des motifs en reliefs ;
- la surface supérieure du corps principal comporte des facettes ;
- au moins une face du corps principal est pourvue d'un revêtement réalisé dans un matériau différent du corps principal ;
- le revêtement est réalisé en métal ;
- l'organe d'affichage comporte au moins un élément de circuit intégré qui est agencé dans l'épaisseur du corps principal ;
- le matériau cristallin est du silicium monocristallin.

L'invention propose aussi une pièce d'horlogerie caractérisée en ce qu'elle comporte au moins un organe d'affichage analogique selon l'une des caractéristiques précédentes.

L'invention propose encore un procédé de fabrication d'organes d'affichage analogique destinés à équiper des pièces d'horlogerie, chaque organe d'affichage analogique comportant un corps principal, caractérisé en ce qu'il comporte au moins une étape de micro-usinage d'une plaque en matériau cristallin à base de silicium de manière à réaliser au moins un corps principal en un tel matériau cristallin.

Ce procédé est facile à mettre en oeuvre pour réaliser en grande série des pièces précises et légères.

Selon d'autres caractéristiques du procédé selon l'invention :
- l'étape de micro-usinage est mise en oeuvre de manière à réaliser simultanément plusieurs organes d'affichage analogique dans la même plaque ;
- l'étape de micro-usinage comporte au moins une étape lithographique visant à reproduire sur la plaque les contours d'au moins une portion du corps principal d'un organe d'affichage analogique ;
- le procédé comporte au moins une étape de dépôt d'un revêtement sur au moins une face du corps principal de chaque organe d'affichage analogique ;
- le procédé comporte au moins une étape de micro-usinage de la face supérieure du corps principal pour y réaliser des motifs en relief ;
- le procédé comporte au moins une étape de micro-usinage de la face supérieure du corps principal pour y réaliser des facettes ;
- le matériau cristallin est du silicium monocristallin.

D'autres caractéristiques et avantages de la présente invention apparaîtront plus clairement à la lecture de la description détaillée qui suit, faite en référence aux dessins annexés donnés à titre d'exemple non limitatifs et dans lesquels :
- les figures 1 à 6 sont des vues en section verticale qui illustrent schématiquement plusieurs étapes d'un procédé de fabrication d'aiguilles de pièces d'horlogerie à partir d'une plaque de silicium conformément aux enseignements de l'invention ;
- les figures 7a et 7b sont des vues de dessus qui représentent schématiquement la plaque de silicium à l'étape illustrée par la figure 6 ;
- la figure 8 est une vue de dessus qui représente schématiquement une montre équipée d'au moins une aiguille obtenue par le procédé selon l'invention ;
- la figure 9 est une vue en coupe verticale qui représente schématiquement une aiguille obtenue par le procédé selon l'invention ;
- la figure 10 est une vue de dessus qui représente schématiquement une aiguille obtenue par le procédé selon l'invention et munie de deux facettes longitudinales ;
- la figure 11 est une vue en coupe verticale selon le plan de coupe 11-11 de l'aiguille de la figure 10.

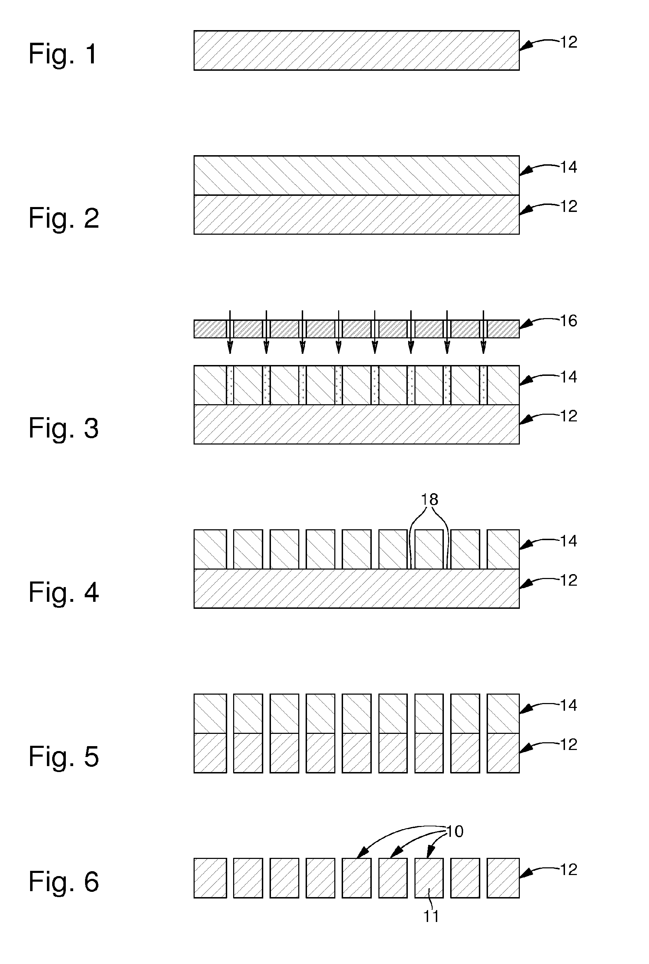

Sur les figures 1 à 7, on a représenté plusieurs étapes d'un procédé pour la fabrication d'organes d'affichage analogique 10 conforme aux enseignements de l'invention.

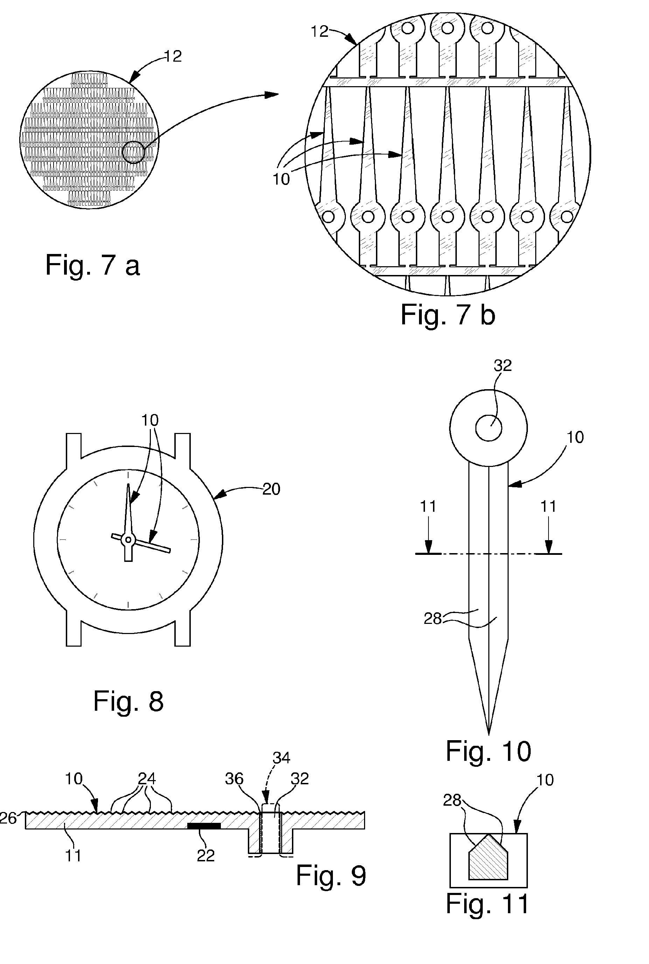

Les organes d'affichage analogique 10 sont ici des aiguilles 10, dont un exemple est représenté schématiquement sur la figure 9.

Conformément aux enseignements de l'invention, chaque aiguille 10 comporte un corps principal 11 qui est réalisé en matériau cristallin à base de silicium.

On entend ici par matériau cristallin à base de silicium un matériau cristallin contenant du silicium tel que le silicium monocristallin, le silicium polycristallin, et le quartz.

De préférence, l'aiguille 10 selon l'invention est micro-usinée dans une plaque de silicium 12 monocristallin telle que celles qui sont utilisées pour la réalisation de circuits électroniques intégrés, ces plaques étant désignées généralement sous le terme de « wafer ».

Avantageusement, une série de plusieurs aiguilles 10 est réalisée dans une même plaque de silicium 12, selon une méthode dite de « batch processing », en faisant appel à des technologies issues du domaine de la microélectronique qui permettent de fabriquer des microstructures mécaniques dans une plaque de silicium 12.

Ces technologies sont déjà mises en oeuvre pour la fabrication de capteurs de pression, d'accéléromètres, de micro-activateurs, de micro-pompes. Elles comportent principalement deux types de procédés de fabrication qui sont les procédés de gravage à sec dits « dry etching », et les procédés de gravage humide dits « wet etching ».

Ces procédés utilisent généralement des techniques de masquage qui permettent d'éliminer localement une couche de matériau d'épaisseur déterminée.

Des procédés de gravage à sec utilisent, par exemple, un faisceau laser ou une source de plasma à haute densité.

Selon un mode de réalisation préféré de l'invention, on utilise des technologies qui permettent de micro-usiner la plaque de silicium 12, de manière à réaliser les aiguilles 10 directement dans l'épaisseur de la plaque de silicium.

L'électropolissage est un exemple de technique utilisée pour le gravage du silicium. Cette technique utilise la propriété pour le silicium monocristallin d'être porosifié par gravage électrochimique anodique dans une solution d'acide fluorhydrique en utilisant une faible densité de courant, cette technique permettant d'éliminer complètement le silicium avec des densités de courant élevées.

Un exemple de mise en oeuvre de la technique d'électropolissage du silicium est décrit dans la publication intitulée "Electrochemical Fabrication of Multiwalled Micro Channels" de R.W. Tjerkstra et al, pages 133-136 des "Proceedings of Micro Total Analysis Systems 98 Workshop", Banff, Canada, dans le cadre de la fabrication de microcanaux coaxiaux dont les parois de séparation sont réalisées en silicium poreux. On pourra se reporter à cette publication, incorporée ici par référence, pour plus de précisions sur ce procédé.

D'autres exemples de procédés de micro-usinage du silicium sont décrits dans l'ouvrage intitulé « Fundamentals of microfabrication », de Marc Madou, édité par CRC Press, et portant la référence ISBN 0-8493-9451-1, incorporé ici par référence, auquel on pourra se reporter pour plus de détails.

On décrit maintenant de manière simplifiée les principales étapes du procédé selon l'invention.

Sur la figure 1, on a représenté une plaque de silicium 12 avant la mise en oeuvre du procédé selon l'invention.

La figure 2 illustre une étape de dépôt d'une couche sacrificielle 14 sur la face supérieure de la plaque de silicium 12.

La figure 3 illustre le traitement de la couche sacrificielle 14, à travers un masque 16, visant à modifier localement la structure de la couche sacrificielle 14 de manière à dessiner sur la plaque de silicium 12 un motif représentant une série d'aiguilles 10.

Sur la figure 4, la couche sacrificielle 14 est développée, c'est-à-dire que les portions de couche sacrificielle 14 traitées ont été éliminées, de sorte que la couche sacrificielle 14 laisse apparaître localement des portions 18 de la face supérieure de la plaque de silicium 12.

Sur la figure 5, la plaque de silicium 12 a été gravée à travers la couche sacrificielle, de préférence selon une technique de gravage anisotrope, de sorte que le motif représentant les aiguilles 10 est maintenant dessiné dans l'épaisseur de la plaque de silicium 12.

La couche sacrificielle 14 restante est alors éliminée, comme représentée sur la figure 6.

On obtient alors une plaque de silicium 12 dans laquelle les aiguilles 10 sont prédécoupées et retenues attachées au corps de la plaque 12 par des ponts de matière, comme on l'a représenté sur les figures 7a et 7b.

L'étape finale de la fabrication des aiguilles 10 consiste à détacher les aiguilles de la plaque de silicium 12.

Avantageusement, le procédé selon l'invention peut comporter au moins une étape au cours de laquelle un revêtement, par exemple métallique, est déposé sur le silicium formant les aiguilles 10. Ce revêtement peut-être déposé selon des techniques de dépôt chimique ou physique en phase vapeur (« Chemical Vapour Deposition » ou « Physical Vapour Déposition »).

Le procédé selon l'invention peut aussi comporter une étape de traitement chimique et/ou thermique appliqué sur la surface du silicium formant les aiguilles 10, par exemple en vue de modifier l'aspect de surface du silicium.

On note que des étapes de gravage peuvent aussi être mises en oeuvre de manière à modifier l'aspect de surface du silicium, ou de manière à modifier l'aspect de surface d'un revêtement déposé sur le silicium, en réalisant des motifs géométriques ou autres, ce qui permet d'obtenir des effets optiques intéressants. De tels motifs géométriques peuvent, par exemple, donner un aspect de type guillochage à la surface des aiguilles 10 réalisées dans le silicium. De telles étapes de gravage peuvent être mises en oeuvre lorsque les aiguilles 10 sont encore portées par la plaque de silicium 12.

Selon le mode de réalisation représenté sur la figure 9, la face supérieure de l'aiguille 10 est pourvue de motifs géométriques 24 en relief qui ont été réalisés par gravage du silicium. Un dépôt métallique 26 a été réalisé sur ces motifs géométriques 24 ce qui donne à l'aiguille 10 un aspect extérieur métallique guilloché. On note qu'un tel résultat serait très difficile à obtenir dans le cas d'une aiguille 10 dont le corps principal 11 est en métal.

Selon le mode de réalisation représenté sur les figures 10 et 11, on a réalisé par gravage deux facettes 28 longitudinales dans la face supérieure de l'aiguille 10.

Selon des variantes de réalisation, les motifs 24 et les facettes 28 peuvent posséder des profils incurvés de manière à former des ondulations sur la surface de l'aiguille 10.

On note que le procédé de fabrication d'aiguilles 10 selon l'invention permet de réaliser facilement des aiguilles 10 ayant des formes et des aspects extérieurs très variés.

Avantageusement, le procédé selon l'invention peut être mis en oeuvre en parallèle sur plusieurs plaques de silicium 12, de manière à réaliser simultanément, dans plusieurs plaques de silicium 12, des aiguilles 10 de caractéristiques similaires.

Sur la figure 8, on a représenté une montre 20 qui est pourvue d'au moins une aiguille 10 en silicium réalisée conformément au procédé selon l'invention.

Chaque aiguille 10 est prévue pour être liée en rotation à un axe ou une roue du mouvement horloger (non représenté) de la montre 20. A cet effet, l'aiguille 10 est pourvue ici d'un trou d'axe 32 destiné à être chassé sur un axe d'entraînement 34.

Avantageusement, la surface axiale interne du trou d'axe 32 est pourvue d'une couche 36 de matériau destinée à permettre le chassage de l'aiguille 10 par déformation de la couche 36 ou par glissement contre la couche 36, en limitant les risques de rupture du corps principal 11.

Selon une variante de réalisation, l'aiguille 10 selon l'invention peut être collée ou soudée sur l'axe d'entraînement 34.

Selon un mode de réalisation avantageux de l'invention, qui est représenté sur la figure 9, un élément 22 de circuit intégré est réalisé dans l'épaisseur de la plaque 12 de silicium, dans le corps 11 de l'aiguille 10.

L'élément 22 de circuit intégré peut être réalisé, selon les technologies de fabrication classiques de la microélectronique, avant, pendant, ou après la mise en oeuvre du procédé de fabrication selon l'invention. Ainsi, des éléments 22 de circuit intégré peuvent être préalablement réalisés dans la plaque de silicium 12 telle que représentée sur la figure 1, à partir de laquelle les aiguilles 10 sont fabriquées.

L'élément 22 de circuit intégré peut être raccordé électriquement au circuit de commande de la montre 20, à travers l'arbre de rotation de l'aiguille 10.

L'élément 22 de circuit intégré comporte, par exemple, une diode électroluminescente intégrée dans l'épaisseur de l'aiguille 10. L'aiguille 10 peut ainsi être éclairée par l'intérieur, en exploitant les propriétés de transparence du silicium.

L'élément 22 de circuit intégré peut comporter un capteur prévu pour fournir au circuit de commande de la montre 20 des indications sur la position angulaire de l'aiguille 10 par rapport au cadran.

## Revendications

1. Organe d'affichage analogique (10) équipant une pièce d'horlogerie (20), du type comportant un corps principal (11), **caractérisé en ce que** le corps principal (11) est réalisé en matériau cristallin à base de silicium.

2. Organe d'affichage analogique (10) selon la revendication précédente, **caractérisé en ce que** le corps principal (11) a la forme d'une aiguille (10) horlogère.

3. Organe d'affichage analogique (10) selon l'une quelconque des revendications précédentes, **caractérisé en ce que** la surface supérieure du corps principal (11) comporte des motifs (24) en reliefs.

4. Organe d'affichage analogique (10) selon l'une quelconque des revendications 1 ou 2, **caractérisé en ce que** la surface supérieure du corps principal (11) comporte des facettes (28).

5. Organe d'affichage analogique (10) selon l'une quelconque des revendications précédentes, **caractérisé en ce qu'**au moins une face du corps principal (11) est pourvue d'un revêtement (26) réalisé dans un matériau différent du corps principal (11).

6. Organe d'affichage analogique (10) selon la revendication précédente, **caractérisé en ce que** le revêtement (26) est réalisé en métal.

7. Organe d'affichage analogique (10) selon l'une quelconque des revendications précédentes, **caractérisé en ce qu'**il comporte au moins un élément (22) de circuit intégré qui est agencé dans l'épaisseur du corps principal (11).

8. Organe d'affichage analogique (10) selon l'une quelconque des revendications précédentes, **caractérisé en ce que** le matériau cristallin est du silicium monocristallin.

9. Pièce d'horlogerie (20) **caractérisée en ce qu'**elle comporte au moins un organe d'affichage analogique (10) selon l'une quelconque des revendications précédentes.

10. Procédé de fabrication d'organes d'affichage analogique (10) destinés à équiper des pièces d'horlogerie (20), chaque organe d'affichage analogique (10) comportant un corps principal (11), **caractérisé en ce qu'**il comporte au moins une étape de micro-usinage d'une plaque (12) en matériau cristallin à base de silicium de manière à réaliser au moins un corps principal (11) en un tel matériau cristallin.

11. Procédé de fabrication selon la revendication précédente, **caractérisé en ce que** l'étape de micro-usinage est mise en oeuvre de manière à réaliser simultanément plusieurs organes d'affichage analogique (10) dans la même plaque (12).

12. Procédé de fabrication selon la revendication 10 ou 11, **caractérisé en ce que** l'étape de micro-usinage comporte au moins une étape lithographique visant à reproduire sur la plaque (12) les contours d'au moins une portion du corps principal (11) d'un organe d'affichage analogique (10).

13. Procédé de fabrication selon l'une quelconque des revendications 10 à 12, **caractérisé en ce qu'**il comporte au moins une étape de dépôt d'un revêtement (26) sur au moins une face du corps principal (11) de chaque organe d'affichage analogique (10).

14. Procédé de fabrication selon l'une quelconque des revendications 10 à 13, **caractérisé en ce qu'**il comporte au moins une étape de micro-usinage de la face supérieure du corps principal (11) pour y réaliser des motifs (24) en relief.

15. Procédé de fabrication selon l'une quelconque des revendications 10 à 13, **caractérisé en ce qu'**il comporte au moins une étape de micro-usinage de la face supérieure du corps principal (11) pour y réaliser des facettes (28).

16. Procédé de fabrication selon l'une quelconque des revendications 10 à 15, **caractérisé en ce que** le matériau cristallin est du silicium monocristallin.
